# EUROPEAN PATENT APPLICATION

(11) **EP 2 854 000 A1**
(43) Date of publication of application: **01.04.2015**
(21) Application number: 14174808.7
(22) Date of filing: 27.06.2014
(51) Int. Cl.: G06F 3/044

(54) **Touch window and touch device with the same**

(30) Priority: 30.09.2013 KR 20130115904
(71) Applicant: LG Innotek Co., Ltd., Seoul 100-714 (KR)
(72) Inventor: Kim, In Tae, 100-714 SEOUL (KR); Kim, Hyun Soo, 100-714 SEOUL (KR); Shin, Jun Sik, 100-714 SEOUL (KR); Yang, Joon Hyuk, 100-714 SEOUL (KR); Lee, Jae Hong, 100-714 SEOUL (KR); Koo, Chan Kyu, 100-714 SEOUL (KR)
(74) Representative: Novagraaf Technologies

(57) **Abstract**

Disclosed are a touch window with an improved visibility and a touch device with the same. The touch window includes a substrate; a first sensing electrode (210) aligned on the substrate as a first conductive pattern (1P); and a second sensing electrode (220) aligned on the substrate as a second conductive pattern (2P), wherein the first conductive pattern (1P) and the second conductive pattern (2P) have mutually different directionalities.

## Description

### BACKGROUND

The disclosure relates to a touch window and a touch device including the same.

Recently, a touch panel, which performs an input function through the touch of an image touch deviceed on a touch device by an input device, such as a stylus pen or a hand, has been applied to various electronic appliances.

The touch panel may be typically classified into a resistive touch panel and a capacitive touch panel. In the resistive touch panel, the position of the touch point is detected by detecting the variation of resistance according to the connection between electrodes when pressure is applied to an input device. In the capacitive touch panel, the position of the touch point is detected by detecting the variation in capacitance when a finger of the user is touched on the capacitive touch panel between electrodes.

As the resistive touch panel is repeatedly used, the performance of the resistive touch panel may be degraded and scratch may occur in the resistive touch panel. Accordingly, the capacitive touch panel with superior durability and long life span has been spotlighted.

Indium tin oxide (ITO), which is the most widely used material for the transparent electrode of the touch panel, is expensive and is easy to be physically damaged when the substrate is flexed and bent, so that the electrode property is deteriorated. Therefore, the indium tin oxide (ITO) is not suitable for a flexible device. Further, when the ITO is applied to a touch panel having a large size, a problem occurs due to high resistance.

In order to solve such a problem, researches and studies have been actively performed for a substitute electrode. Particularly, there has been an attempt to replace the ITO with a metallic material having a mesh shape, but a moire phenomenon occurs due to the mesh shape. The moire phenomenon occurs when periodical stripes overlap with each other. Since adjacent stripes overlap with each other, a thickness of a stripe is thickened so that the stripe is spotlighted as compared with other stripes. In order to compensate for the moire phenomenon, a haze film is put on a metallic material having the mesh shape to attenuate the moire phenomenon. However, transmissivity of the touch panel is reduced due to the haze film so that the whole performance of a touch device may be degraded. Further, a thickness of the touch panel may be increased.

### SUMMARY

The embodiment provides a touch window with an improved visibility and a touch device with the same.

According to the embodiment, there is provided a touch window including: a substrate; a first sensing electrode aligned on the substrate as a first conductive pattern; and a second sensing electrode aligned on the substrate as a second conductive pattern, wherein the first conductive pattern and the second conductive pattern have mutually different directionalities.

The touch window according to the embodiment includes a sensing electrode having the shape of a mesh. As the sensing electrode may have the shape of a mesh, the pattern of the sensing electrode may not be viewed in a screen region. That is, although the sensing electrode includes metal, the pattern of the sensing electrode may not be viewed. Further, even if the sensing electrode is applied to a large-sized touch window, resistance of the touch window can be reduced. In addition, when the sensing electrode is formed by a printing process, the touch window of a high quality can be ensured by improving a printing quality.

Further, in the embodiment, the moire phenomenon can be prevented and the visibility can be improved by a predetermined arrangement of the conductive pattern. In addition, according to the embodiment, the moire phenomenon can be attenuated without an additional haze film. That is, the moire phenomenon can be prevented without increasing the thickness and degrading the transmissivity. Accordingly, the whole performance and the reliability of the touch device can be improved.

### BRIEF DESCRIPTION OF THE DRAWINGS

FIG. 1 is a schematic plan view showing a touch window according to an embodiment.
FIG. 2 is an exploded perspective view showing the touch window according to the embodiment.
FIG. 3 is a view showing one surface of a first substrate included in the touch window according to the embodiment.
FIG. 4 is a view showing one surface of a second substrate included in the touch window according to the embodiment.
FIG. 5 is a plan view taken along line A-A' of FIG. 2.
FIG. 6 is a plan view taken along line A-A' of FIG. 2.
FIG. 7 is an exploded perspective view showing a touch device in which a touch window is disposed on a display panel according to an embodiment.

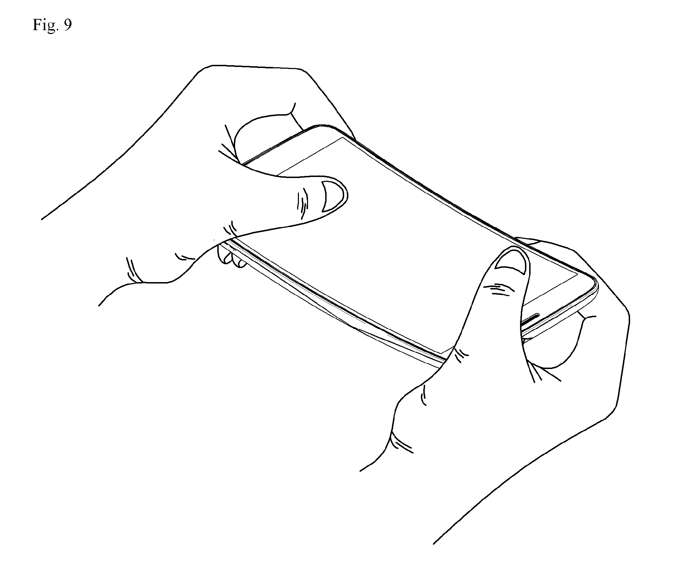

FIGS. 8 to 10 are perspective views showing touch devices to which a touch device is applied according to an embodiment.

### DETAILED DESCRIPTION OF THE EMBODIMENTS

In the following description of the embodiments, it will be understood that, when a layer (or film), a region, a pattern, or a structure is referred to as being "on" or "under" another substrate, another layer (or film), another region, another pad, or another pattern, it can be "directly" or "indirectly" on the other substrate, layer (or film), region, pad, or pattern, or one or more intervening layers may also be present. Such a position of the layer has been described with reference to the drawings.

The thickness and size of each layer shown in the drawings may be exaggerated, omitted or schematically drawn for the purpose of convenience or clarity. In addition, the size of elements does not utterly reflect an actual size.

Hereinafter, the embodiment will be described with reference to accompanying drawings.

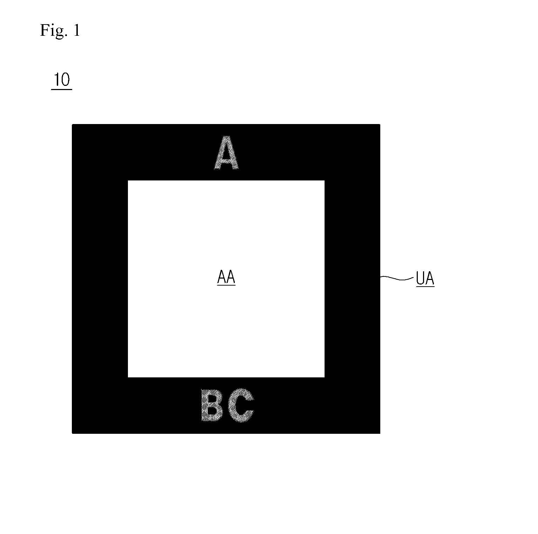

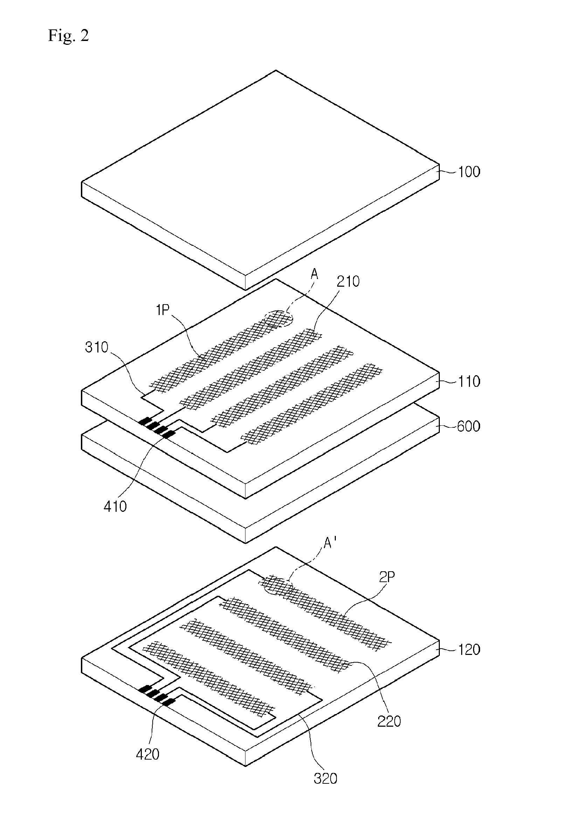

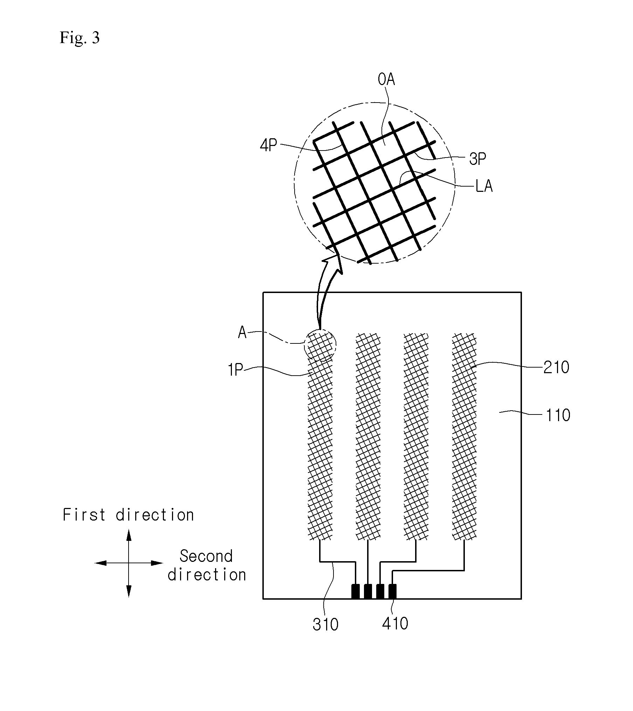

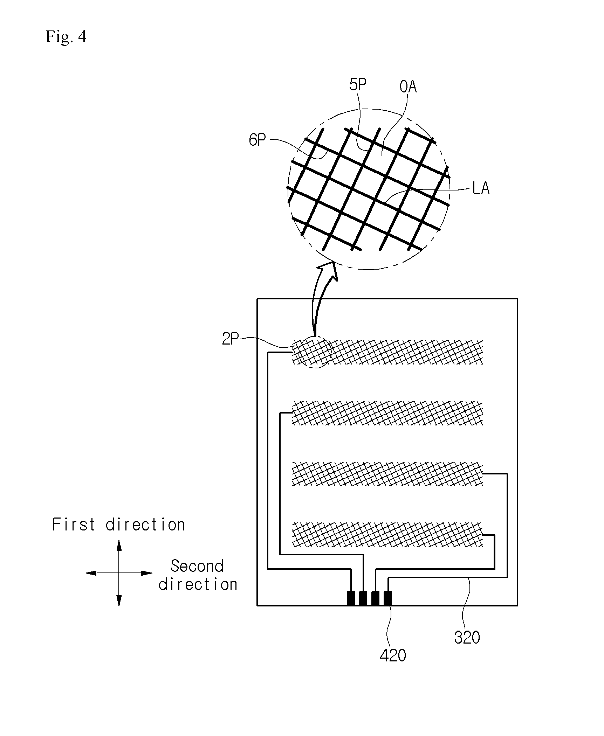

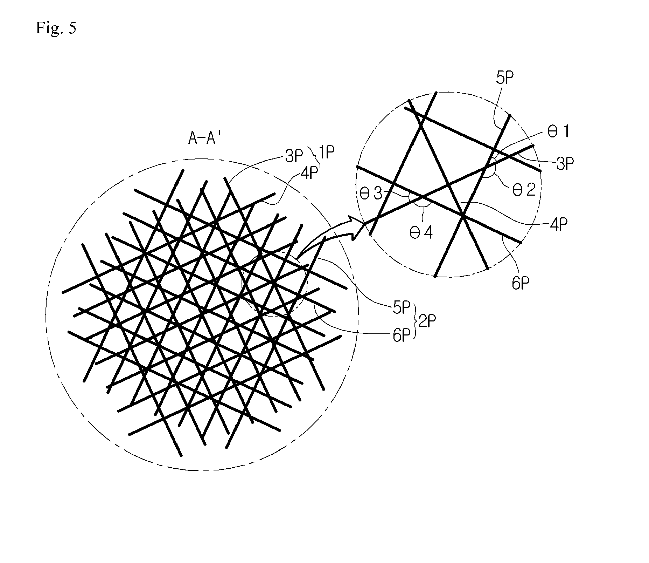

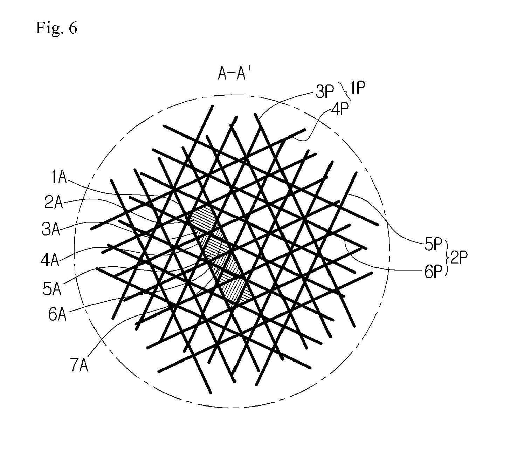

A touch window according to the embodiment will be described with reference to FIGS. 1 to 6. FIG. 1 is a schematic plan view showing a touch window according to an embodiment. FIG. 2 is an exploded perspective view showing the touch window according to the embodiment. FIG. 3 is a view showing one surface of a first substrate included in the touch window according to the embodiment. FIG. 4 is a view showing one surface of a second substrate included in the touch window according to the embodiment. FIG. 5 is a plan view taken along line A-A' of FIG. 2. FIG. 6 is a plan view taken along line A-A' of FIG. 2.

Referring to FIG. 1, a touch window 10 according to the embodiment includes substrates 100, 110, and 120 having an active area AA, in which a position of an input device (e.g., finger) is detected, and an unactive area UA provided at a peripheral portion of the active area AA.

In this case, sensing electrodes 210 and 220 may be formed in the active area AA such that the input device may be sensed. Wires 310 and 320 electrically connecting the sensing electrodes 210 and 220 to each other may be formed in the unactive area UA. In addition, an external circuit connected to the wires 310 and 320 may be placed in the unactive area UA.

If an input device such as a finger is touched on the touch panel, the difference in capacitance is made on a touched portion by the input device, and the touched portion representing the difference in the capacitance may be detected as a touch point.

Referring to FIG. 2, the substrates include a cover substrate 100, a first substrate 110, and a second substrate 120.

The cover substrate 100 is disposed at the uppermost portion of the touch window. The cover substrate 100 may protect elements disposed under the cover substrate 100. The cover substrate 100 may include a glass substrate or a plastic substrate including polyethylene terephthalate (PET) film or resin. However, the embodiment is not limited thereto. The cover substrate 100 may include various materials having strength sufficient for a protective function.

Referring to FIGS. 2 and 3, the first substrate 110 may be disposed under the cover substrate 100. The first substrate 110 may support a first sensing electrode 210, a first wire 310, and a first pad part 410 formed on the first substrate 110. The first substrate 110 may include a glass substrate or a plastic substrate including polyethylene terephthalate (PET) film. However, the embodiment is not limited thereto. The first substrate 110 may include various materials in which the first sensing electrode 210, the first wire 310, and the first pad part 410 may be formed.

The first sensing electrode 210 is disposed in an active area AA of the first substrate 110. The first sensing electrode 210 may detect a position of an input device.

The first sensing electrode 210 may extend in a first direction. Meanwhile, the first sensing electrode 210 is arranged in the shape of a mesh. In detail, the first sensing electrode 210 includes a first conductive pattern 1P. The first conductive pattern 1P may include a third pattern 3P and a fourth pattern 4P crossing each other.

The first sensing electrode 210 includes a mesh opening OA and a mesh line LA. In this case, a line width of the mesh line LA may be in the range of 0.1 µm to 10 µm. A mesh line LA of 0.1 µm or less may not be formed due to the characteristic of the manufacturing process. If the line width is 10 µm or less, the pattern of the first sensing electrode 210 may not be viewed. Preferably, the line width of the mesh line LA may be in the range of 1 µm to 5 µm.

Meanwhile, as shown in FIG. 3, the mesh opening OA may have the shape of a rectangle, but the embodiment is not limited thereto. The mesh opening OA may have various shapes such as a polygonal shape including a diamond shape, a pentagonal shape, or a hexagonal shape, or a circular shape.

As the first sensing electrode 210 has the shape of the mesh, the pattern of the first sensing electrode 210 may not be viewed in the active area AA. In other words, even when the first sensing electrode 210 includes metal, the pattern may not be viewed. In addition, even when the first sensing electrode 210 is applied to a large-size touch window, the resistance of the touch window can be reduced. Further, when the first sensing electrode 210 is formed through the printing process, the printing quality can be improved so that the high-quality touch window can be ensured.

The first sensing electrode 210 may include a transparent conductive material that allows electricity to flow therethrough without interrupting transmission of light. For example, the first sensing electrode 210 may include metallic oxide such as indium tin oxide, indium zinc oxide, copper oxide, tin oxide, zinc oxide, or titanium oxide. The first sensing electrode 210 may include a nanowire, a sensitive nanowire, a carbon nanotube (CNT), grapheme, conductive polymer or various metals. For example, the first sensing electrode 210 may include metals such as Cr, Ni, Cu, Al, Ag and Mo, and the alloy thereof.

The unactive area UA of the first substrate 110 is provided therein with a first wire 310 and a first pad part 410.

The first wire 310 is electrically connected to the first sensing electrode 210.

The first wire 310 may be formed of a metal having excellent electric conductivity. For example, the first wire 310 may include Cr, Ni, Cu, Al, Ag and Mo, and the alloy thereof.

A first pad part 410 is positioned at an end of the first wire 310. The first pad part 410 may be connected to a printed circuit board. Various types of printed circuit boards may be applicable. For example, a flexible printed circuit board (FPCB) is applicable as the printed circuit board.

Meanwhile, the first sensing electrode 210 may be directly formed on the cover substrate 100, and the first substrate 110 may be omitted. Accordingly, a thickness of the touch window may be reduced and various structures may be ensured.

Referring to FIGS. 2 and 4, the second substrate 120 may be disposed under the cover substrate 100. Further, the second substrate 120 may be spaced apart from a lower portion of the first substrate 110. A transparent adhesion layer 600 is disposed between the first substrate 110 and the second substrate 120 to adhere the first substrate 110 to the second substrate 120. The second substrate 120 may support a second sensing electrode 220, a second wire 320, and a second pad part 420 formed on the second substrate 120. The second substrate 120 may include a glass substrate or a plastic substrate including polyethylene terephthalate (PET) film. However, the embodiment is not limited thereto. The second substrate 120 may include various materials in which the second sensing electrode 220, the second wire 320, and the second pad part 420 may be formed.

The second sensing electrode 220 is disposed in an active area AA of the second substrate 120. The second sensing electrode 220 may detect a position of an input device.

The second sensing electrode 220 may extend in a second direction crossing the first direction. Meanwhile, the second sensing electrode 220 is arranged in the shape of a mesh. In detail, the second sensing electrode 220 includes a second conductive pattern 2P. The second conductive pattern 2P may include a fifth pattern 5P and a sixth pattern 6P crossing each other.

The second sensing electrode 220 includes a mesh opening OA and a mesh line LA. In this case, a line width of the mesh line LA may be in the range of 0.1 µm to 10 µm. A mesh line LA of 0.1 µm or less may not be formed due to the characteristic of the manufacturing process. If the line width is 10 µm or less, the pattern of the second sensing electrode 220 may not be viewed. Preferably, the line width of the mesh line LA may be in the range of 1 µm to 5 µm.

Meanwhile, as shown in FIG. 3, the mesh opening OA may have the shape of a rectangle, but the embodiment is not limited thereto. The mesh opening OA may have various shapes such as a polygonal shape including a diamond shape, a pentagonal shape, or a hexagonal shape, or a circular shape.

As the second sensing electrode 220 has the shape of the mesh, the pattern of the first sensing electrode 210 may not be viewed in the active area AA. In other words, even when the second sensing electrode 220 includes metal, the pattern may not be viewed. In addition, even when the second sensing electrode 220 is applied to a large-size touch window, the resistance of the touch window can be reduced. Further, when the second sensing electrode 220 is formed through the printing process, the printing quality can be improved so that the high-quality touch window can be ensured.

The second sensing electrode 220 may include the same or similar material as that of the first sensing electrode 210. The second sensing electrode 220 may include a transparent conductive material that allows electricity to flow therethrough without interrupting transmission of light. For example, the second sensing electrode 220 may include metallic oxide such as indium tin oxide, indium zinc oxide, copper oxide, tin oxide, zinc oxide, or titanium oxide. The second sensing electrode 220 may include a nanowire, a sensitive nanowire, a carbon nanotube (CNT), grapheme, conductive polymer or various metals. For example, the first sensing electrode 210 may include metals such as Cr, Ni, Cu, Al, Ag and Mo, and the alloy thereof.

The unactive area UA of the second substrate 120 is provided therein with a second wire 320 and a second pad part 420.

The second wire 320 is electrically connected to the second sensing electrode 220.

The second wire 320 may be formed of a metal having excellent electric conductivity. For example, the second wire 320 may include Cr, Ni, Cu, Al, Ag and Mo, and the alloy thereof.

A second pad part 420 is positioned at an end of the second wire 320. The second pad part 420 may be connected to a printed circuit board. Various types of printed circuit boards may be applicable. For example, a flexible printed circuit board (FPCB) is applicable as the printed circuit board.

Meanwhile, the first sensing electrode 210 and the second sensing electrode 220 may be formed on a top surface or a bottom surface of the second substrate 120. That is, the first sensing electrode 210 may be disposed on the top surface of the second substrate 120 and the second sensing electrode 220 may be disposed on the bottom surface of the second substrate 120. Alternatively, the first sensing electrode 210 and the second sensing electrode 220 may be aligned on the same plane with the second substrate 120. Accordingly, the first substrate 110 may be omitted. The first sensing electrode 210 and the second sensing electrode 220 may be aligned on the same plane with the cover substrate 100. Accordingly, all of the first substrate 110 and the second substrate 120 may be omitted. Accordingly, a thickness of the touch window may be reduced, and a touch window having various structures may be ensured.

Meanwhile, the first conductive pattern 1P and the second conductive pattern 2P may have mutually different directionalities. The first conductive pattern 1P may cross the second conductive pattern 2P. The first conductive pattern 1P may not be parallel to the second conductive pattern 2P. Accordingly, the third conductive pattern 3P, the fourth pattern 4P, the fifth conductive pattern 5P, and the sixth conductive pattern 6P may have mutually different directionalities.

Referring to FIG. 2, when viewed from a top surface of the touch window, the first conductive pattern 1P and the second conductive pattern 2P may look like an overlap pattern. In detail, a part A of the first conductive pattern 1P and a part A' of the second conductive pattern 2P may look like an overlap part. Thus, as shown in FIG. 5, when viewed from a top of the touch window, the first conductive pattern 1P and the second conductive pattern 2P may look like an overlap pattern.

In this case, an angle θ1 between the first conductive pattern 1P and the second conductive pattern 2P may be in the range of 20° to 50°. In detail, an angle θ1 between the third conductive pattern 3P and the fifth conductive pattern 5P may be in the range of 20° to 50°. In this manner, when the first conductive pattern 1P and the second conductive pattern 2P are aligned while forming an angle therebetween, the moire phenomenon can be attenuated and the visibility of the touch window can be improved.

Meanwhile, an angle θ2 between the first conductive pattern 1P and the second conductive pattern 2P may be in the range of 130° to 160°. In detail, an angle θ2 between the third conductive pattern 3P and the fifth conductive pattern 5P may be in the range of 130° to 160°. In this manner, when the first conductive pattern 1P and the second conductive pattern 2P are aligned while forming an angle therebetween, the moire phenomenon can be attenuated and the visibility of the touch window can be improved.

Meanwhile, an angle θ3 between the first conductive pattern 1P and the second conductive pattern 2P may be in the range of 40° to 70°. In detail, an angle θ3 between the third conductive pattern 3P and the sixth conductive pattern 6P may be in the range of 40° to 70°. In this manner, when the first conductive pattern 1P and the second conductive pattern 2P are aligned while forming an angle therebetween, the moire phenomenon can be attenuated and the visibility of the touch window can be improved.

Meanwhile, an angle θ4 between the first conductive pattern 1P and the second conductive pattern 2P may be in the range of 110° to 140°. In detail, an angle θ4 between the third conductive pattern 3P and the sixth conductive pattern 6P may be in the range of 110° to 140°. In this manner, when the first conductive pattern 1P and the second conductive pattern 2P are aligned while forming an angle therebetween, the moire phenomenon can be attenuated and the visibility of the touch window can be improved.

Meanwhile, referring to FIG. 6, at least two types of areas 1A, 2A, 3A, 4A, 5A, 6A, 7A... and NA may be formed between the first conductive pattern 1P and the second conductive pattern 2P. That is, at least two types of areas 1A, 2A, 3A, 4A, 5A, 6A, 7A... and NA may be formed among the third pattern 3P, the fourth pattern 4P, the fifth pattern 5P, and the sixth pattern 6P. In detail, as shown in FIG. 6, areas 1A, 2A, 3A, 4A, 5A, 6A, 7A... and NA between the first conductive pattern 1P and the second conductive pattern 2P may include various types such as a first area 1A, a second area 2A, a third area 3A, a fourth area 4A, a fifth area 5A, a sixth area 6A, and a seventh area 7A. Although only the first area 1A to the seventh area 7A are illustrated in drawings, various types of areas, which are not illustrated, may be formed.

Accordingly, the moire phenomenon between the first conductive pattern 1P and the second conductive pattern 2P can be attenuated. Thus, the visibility of the touch window can be improved.

In addition, according to the embodiment, the moire phenomenon can be attenuated without an additional haze film. That is, the moire phenomenon can be prevented without increasing the thickness and degrading the transmissivity. Accordingly, the whole performance and reliability of the touch device can be improved.

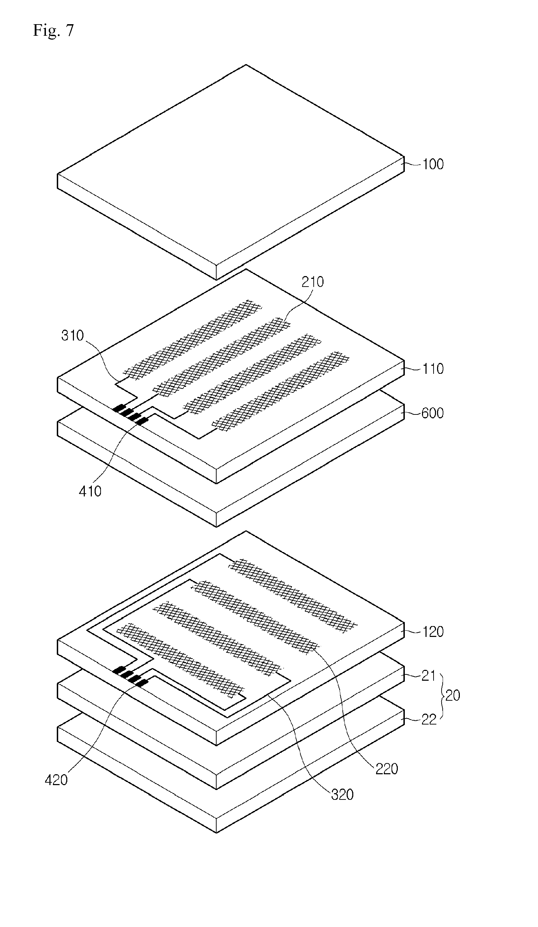

Meanwhile, referring to FIG. 7, the touch window 10 may be disposed on a display panel 20 serving as a driver. The touch window 10 may be combined with the display panel 20, so that a touch device may be implemented.

A touch device region to output an image is formed in the display panel 20. A display panel applied to the touch device may generally include an upper substrate 21 and a lower substrate 22. A data line, a gate line and a thin-film transistor (TFT) may be formed in the lower substrate 22. The upper substrate 21 may be adhesive to the lower substrate 22 such that the elements provided on the lower substrate 22 may be protected.

The display panel 20 may be formed in various types according to the type of touch device. That is, the touch device according to the embodiment may include a liquid-crystal device (LCD), a field emission display, a plasma display panel (PDP), an organic light-emitting diode (OLED), and an electronic paper display (EPD). Thus, the display panel 20 may be implemented in various types.

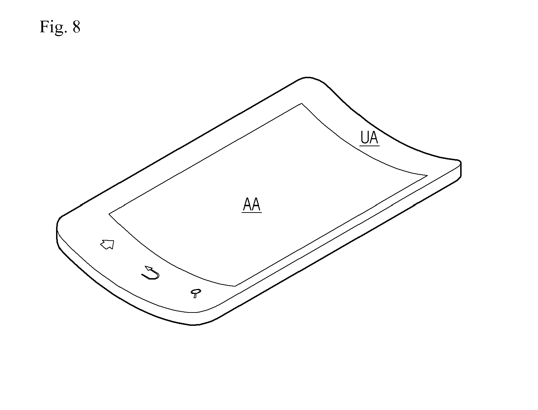

Meanwhile, referring to FIG. 8, the touch window may include a curved touch window. Thus, a touch device including the touch window may be a curved touch device. In addition, the first sensing electrode 210 and the second sensing electrode 220 may include a conductive pattern, so that the bending property and the reliability of the touch window may be improved.

In addition, the touch window may include a flexible touch window. Thus, the touch device may be flexible touch device. Therefore, a user may allow the touch device to be flexible or bendable with his hand. In addition, the first or second sensing electrode 210 or 220 may include a conductive pattern, so that the bending property and the reliability of the touch window may be improved.

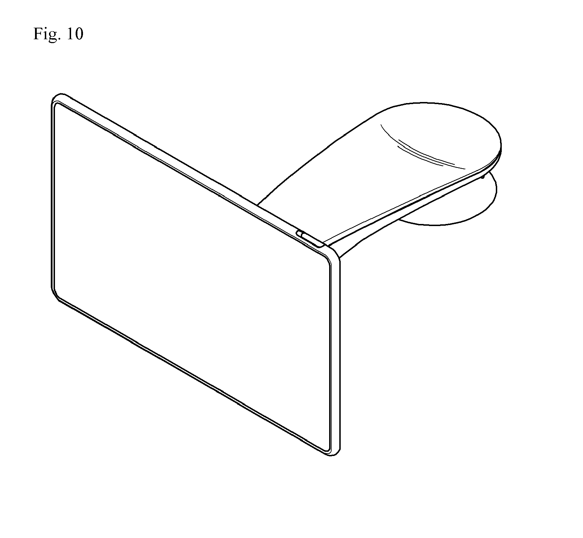

Meanwhile, referring to FIG. 10, the touch window may be applied to a vehicle as well as a touch device such as a mobile terminal. Although FIG. 20 shows a navigation system of a vehicle, the embodiment is not limited thereto. Accordingly, the touch window is applied to a dashboard as well as a PND (Personal Navigation Display) so that a CID (Center Information Display) may be implemented. However, the embodiment is not limited to the embodiment. In other words, the touch device may be used in various electronic products.

Any reference in this specification to "one embodiment," "an embodiment," "example embodiment," etc., means that a particular feature, structure, or characteristic described in connection with the embodiment is included in at least one embodiment of the invention. The appearances of such phrases in various places in the specification are not necessarily all referring to the same embodiment. Further, when a particular feature, structure, or characteristic is described in connection with any embodiment, it is submitted that it is within the purview of one skilled in the art to effect such feature, structure, or characteristic in connection with other ones of the embodiments.

Although embodiments have been described with reference to a number of illustrative embodiments thereof, it should be understood that numerous other modifications and embodiments can be devised by those skilled in the art that will fall within the spirit and scope of the principles of this disclosure. More particularly, various variations and modifications are possible in the component parts and/or arrangements of the subject combination arrangement within the scope of the disclosure, the drawings and the appended claims. In addition to variations and modifications in the component parts and/or arrangements, alternative uses will also be apparent to those skilled in the art.

Further, although the conductive patterns are described and illustrated as a rectangular pattern or a straight line pattern, the embodiment is not limited thereto. In other words, the conductive patterns may include various patterns such as a curved pattern or an oval pattern.

## Claims

1. A touch window comprising:
a substrate;
a first sensing electrode (210) aligned on the substrate as a first conductive pattern (IP); and
a second sensing electrode (220) aligned on the substrate as a second conductive pattern (2P),
wherein the first conductive pattern (1P) and the second conductive pattern (2P) have mutually different directionalities.

2. The touch window of claim 1, wherein an angle between the first conductive pattern (1P) and the second conductive pattern (2P) is in a range of 20° to 50°.

3. The touch window of claim 1, wherein an angle between the first conductive pattern (1P) and the second conductive pattern (2P) is in a range of 140° to 160°.

4. The touch window of claim 1, wherein an angle between the first conductive pattern (1P) and the second conductive pattern (2P) is in a range of 50° to 70°.

5. The touch window of claim 1, wherein an angle between the first conductive pattern (1P) and the second conductive pattern (2P) is in a range of 110° to 130°.

6. The touch window of any one of claims 1 to 5, wherein the first conductive pattern (1P) comprises a third pattern (3P) and a fourth pattern (4P) crossing each other, and
the second conductive pattern (2P) comprises a fifth pattern (5P) and a sixth pattern (6P) crossing each other.

7. The touch window of claim 6, wherein the third pattern (3P), the fourth pattern (4P), the fifth pattern (5P), and the sixth pattern (6P) have mutually different directionalities.

8. The touch window of claim 6, wherein an angle between the third conductive pattern (3P) and the fifth conductive pattern (5P) is in a range of 20° to 50°.

9. The touch window of claim 6, wherein an angle between the third conductive pattern (3P) and the fifth conductive pattern (5P) is in a range of 130° to 160°.

10. The touch window of claim 6, wherein an angle between the third conductive pattern (3P) and the sixth conductive pattern (6P) is in a range of 40° to 70°.

11. The touch window of claim 6, wherein an angle between the third conductive pattern (3P) and the sixth conductive pattern (6P) is in a range of 110° to 140°.

12. A touch window comprising:
a substrate;
a first sensing electrode (210) aligned on the substrate as a first conductive pattern (IP); and
a second sensing electrode (220) aligned on the substrate as a second conductive pattern (2P),
wherein at least two types of areas are formed between the first conductive pattern (1P) and the second conductive pattern (2P).

13. A touch device comprising:
a touch window (10); and
a driver on the touch window (10),
wherein the touch window (10) comprises:
a substrate;
a first sensing electrode (210) aligned on the substrate as a first conductive pattern (IP); and
a second sensing electrode (220) aligned on the substrate as a second conductive pattern (2P), and
wherein the first conductive pattern (1P) and the second conductive pattern (2P) have mutually different directionalities.

14. The touch device of claim 13, wherein the touch window (10) comprises a curved touch window or a flexible touch window.
